# EUROPÄISCHE PATENTSCHRIFT

(11) **EP 2 044 455 B1**
(45) Veröffentlichungstag und Bekanntmachung des Hinweises auf die Patenterteilung: **12.10.2011**
(21) Anmeldenummer: 07785592.2
(22) Anmeldetag: 05.07.2007
(51) Int. Cl.: G01R 33/383

(54) **VORRICHTUNG ZUR BEAUFSCHLAGUNG EINER PROBE MIT EINEM MAGNETFELD**
APPARATUS FOR APPLYING A MAGNETIC FIELD TO A SAMPLE
DISPOSITIF POUR L'APPLICATION D'UN CHAMP MAGNÉTIQUE À UN ÉCHANTILLON

(30) Priorität: 26.07.2006 DE 102006034472
(43) Veröffentlichungstag der Anmeldung: 08.04.2009
(73) Patentinhaber: Forschungszentrum Jülich GmbH, 52425 Jülich (DE)
(72) Erfinder: BLÜMLER, Peter, 52428 Jülich (DE); SOLTNER, Helmut, 52459 Inden (DE)
(86) Internationale Anmeldenummer: PCT/DE2007/001186
(87) Internationale Veröffentlichungsnummer: WO 2008/011859

(56) Entgegenhaltungen:
- EP-A2- 0 481 761
- DE-U1- 20 310 453
- US-A1- 2005 210 629
- H. RAICH, P. BLÜMLER: "Design and construction of a dipolar Halbach array with a homogeneous field from identical bar magnets: NMR Mandhalas" CONCEPTS IN MAGNETIC RESONANCE, Bd. 23B, 2004, Seiten 16-25, XP008084096 ISSN: 1043-7347
- G. EIDMANN ET AL: "The NMR MOUSE, a mobile universal surface explorer" JOURNAL OF MAGNETIC RESONANCE, SERIES A, Bd. 122, September 1996 (1996-09), Seiten 104-109, XP002452807 ISSN: 1064-1858

## Beschreibung

Die Erfindung betrifft eine Vorrichtung zur Beaufschlagung einer Probe mit einem Magnetfeld.

### Stand der Technik

Verborgene Strukturen und insbesondere Defekte im Inneren von Proben können durch magnetische Resonanzmethoden, wie beispielsweise die Elektronen- oder Kernspinresonanz, ausfindig gemacht werden. Dabei wird die Probe mit einem statischen Magnetfeld beaufschlagt. Dieses Magnetfeld hebt die Entartung von quantenmechanischen Zuständen in der Probe auf, bewirkt also, dass verschiedenen Zuständen verschiedene Energieniveaus zugeordnet werden. Zusätzlich wird ein hochfrequentes Magnetfeld in die Probe eingekoppelt, das im Resonanzfall Übergänge zwischen diesen Zuständen herbeiführt.

Das statische Magnetfeld muss insbesondere Für die Kernspinresonanz sehr stark und auch homogen sein. Für den mobilen Einsatz ist es zweckmäßig, magnetische Ringe umfassende Magnetanordnungen zu verwenden, in deren Innerem ein starkes und in weiten Bereichen homogenes Magnetfeld entsteht.

Nachteilig können diese Ringe nicht verwendet werden, um längliche Proben, deren Enden nicht zugänglich sind, in ihrem Inneren mit einem solchen starken und homogenen Magnetfeld zu beaufschlagen. Beispiele für derartige Proben sind Baumstämme oder Rohrleitungen.

Aus dern Stand der Technik sind Vorrichtungen bekannt, die zur Aufnahme einer längliche Probe aufgeklappt und anschließend wieder verschlossen werden können (EP 0 481 761 A2). Aus DE 203 10453 U1 ist eine Vorrichtung bekannt, die aus Halbschalen mit halbkreisförmigem Querschnitt besteht, die geöffnet werden kann, um eine längliche Probe von einem Magnetfeld zu umschließen, wobei sich in den Halbschalen eine Magnetkernteil befindet, der magnetisierende Eigenschaften aufweist.

In den nach dem Stand der Technik bekannten Vorrichtungen können hohe Magnetisierungskräfte vorherrschen, so dass zum Teil hohe Kräfte aufgewandt werden müssen, um die Vorrichtungen zu öffnen. Dies erschwert eine einfache Handhabung und einen sicheren Umgang mit den bekannten Vorrichtungen. Eine Möglichkeit zur Regulierung dieser Magnetisierungskräfte ist aus dem Stand der Technik nicht bekannt.

### Aufgabe und Lösung

Aufgabe der Erfindung ist daher, eine Vorrichtung zur Verfügung zu stellen, die es ermöglicht, insbesondere längliche Proben, deren Enden nicht zugänglich sind, in ihrem Inneren mit einem möglichst starken und möglichst homogenen Magnetfeld zu beaufschlagen.

Diese Aufgabe wird erfindungsgemäß gelöst durch Vorrichtungen gemäß Haupt- und Nebenanspruch. Weitere vorteilhafte Ausgestaltungen ergeben sich jeweils aus den darauf rückbezogenen Unteransprüchen.

### Gegenstand der Erfindung

Im Rahmen der Erfindung wurde eine Vorrichtung zur Beaufschlagung einer Probe mit einem Magnetfeld entwickelt. Diese Vorrichtung umfasst mindestens zwei zumindest teilweise magnetische schleifenförmige Körper mit einer gemeinsamen Durchtrittsöffnung für die Probe, die gegeneinander drehbar angeordnet sind.

Die Probe kann insbesondere länglich sein. Beispiele für längliche Proben sind ein Baum oder eine Rohrleitung, deren Inneres mit einer Magnetresonanzmethode zu untersuchen ist und daher mit einem Magnetfeld beaufschlagt werden muss.

Unter einem schleifenförmigen Körper im Sinne dieser Erfindung werden neben zweidimensionalen Strukturen, wie beispielsweise einem Ring oder einer rechteckigen Schleife, auch dreidimensionale Strukturen, wie beispielsweise eine Halbkugel, verstanden, die einen Raum wenigstens teilweise umschließen.

Bei den zweidimensionalen Strukturen kann es sich um radialsymmetrische Ringe oder Ringe handeln, die von der Kreisform abweichen, wie beispielsweise Ellipsen oder andere von der exakten Kreisform abweichende Formen. Es können auch andere polygonale Ringe Verwendung finden. Analoge Geometrien können auch dreidimensional ausgeführt sein.

Die gemeinsame Durchtrittsöffnung ist vorteilhaft, damit die Vorrichtung eine längliche Probe ganz umschließen und so von allen Seiten mit einem Magnetfeld beaufschlagen kann. Dies ist insbesondere dann wichtig, wenn in der länglichen Probe ein möglichst homogenes Magnetfeld erzeugt werden soll.

Die Körper sind drehbar gegeneinander angeordnet, um über ihre relative Stellung zueinander das durch ihr Zusammenspiel erzeugte resultierende Magnetfeld in der Probe in Richtung und Stärke regulieren zu können. In der Regel werden die Körper koplanar gegeneinander gedreht.

Es können mehr als zwei, beispielsweise auch drei oder vier Körper gegeneinander drehbar angeordnet sein. Damit kann beispielsweise die Genauigkeit, mit der die gewünschte Feldverteilung in der gemeinsamen Durchtrittsöffnung realisiert wird, verbessert werden.

Die Körper sind beispielsweise dann gegeneinander drehbar, wenn sie in einer Ebene drehbar gelagert sind und der größte Außendurchmesser des einen Körpers geringer ist als der kleinste Innendurchmesser des anderen Körpers.

Es sind aber beispielsweise auch zwei jeweils drehbar gelagerte, übereinander gelegte Ringe mit vorzugsweise gleichen Abmessungen gegeneinander drehbar.

Erfindungsgemäß bestehen die Körper nun jeweils aus mindestens zwei mit Kopplungsmitteln verbundenen Segmenten, wobei an jedem Körper mindestens ein Kopplungsmittel lösbar ausgestaltet ist und mindestens ein weiteres Kopplungsmittel eine Klappbewegung zulässt.

Als lösbar ausgestaltetes Kopplungsmittel ist beispielsweise eine Schnalle oder ein Schraubverschluss geeignet.

Als Kopplungsmittel, das eine Klappbewegung zulässt, ist beispielsweise ein Scharnier geeignet.

Da die Vorrichtung in mit Kopplungsmitteln verbundene Segmente unterteilt ist, kann sie um eine längliche Probe, deren Enden nicht zugänglich sind, herum angelegt werden und diese dann ganz umschließen. Die Vorrichtung kann in diesem Zustand die Probe von allen Seiten mit einem Magnetfeld beaufschlagen. Beispiele für längliche Proben, deren Enden nicht zugänglich sind, sind Baumstämme oder Rohrleitungen.

Es wurde erkannt, dass hierbei das Zusammenspiel mit der drehbaren Lagerung der Körper gegeneinander wichtig ist. Durch die drehbare Lagerung können die Körper in eine Lage zueinander gebracht werden, in der das resultierende Magnetfeld in der gemeinsamen Durchtrittsöffnung und auch am lösbar ausgestalteten Kopplungsmittel verringert wird oder verschwindet. Die Vorrichtung kann dadurch mit geringem Kraftaufwand geöffnet und geschlossen werden. Für die eigentliche Untersuchung der Probe können die Körper nach dem Arretieren des lösbar ausgestalteten Kopplungsmittels in eine Lage zueinander gebracht werden, in der das resultierende Magnetfeld in der gemeinsamen Durchtrittsöffnung und damit auch in der Probe bestimmte vorteilhafte Eigenschaften aufweist. Beispielsweise kann für Kernspinresonanz-Untersuchungen ein möglichst starkes und möglichst homogenes Feld eingestellt werden. Für Elektronenspinresonanz-Untersuchungen kann ein Feld eingestellt werden, dessen Stärke möglichst genau einem vorgegebenen Wert entspricht. Elektronenspinresonanz arbeitet mit Mikrowellen, für die nur Quellen (Klystrons) mit bestimmten festen Frequenzen oder Frequenzbändern zur Verfügung stehen. Diesen festen Frequenzen oder Frequenzbändern muss das Magnetfeld angepasst werden.

Das Öffnen und Schließen mit geringem Kraftaufwand ermöglicht nicht nur eine bequemere Handhabung der Vorrichtung, sondern erhöht auch die Arbeitssicherheit beim Umgang mit der Vorrichtung. Bei technisch relevanten Magnetisierungen der Körper können sich die durch das lösbar ausgestaltete Kopplungsmittel verbundenen Segmente eines einzelnen Körpers mit Kräften anziehen oder abstoßen, die durchaus zum Durchtrennen von Fingern ausreichen.

Alternativ bestehen die Körper jeweils aus mindestens zwei mit Kopplungsmitteln verbundenen Segmenten, wobei an jedem Körper mindestens zwei Kopplungsmittel lösbar ausgestaltet sind. Durch Lösen der Kopplungsmittel kann jeder Körper dann in mindestens zwei Teile zerlegt werden. Diese Teile können dann um die Probe herum angelegt und durch Arretieren der Kopplungsmittel wieder verbunden werden. Vor dem Trennen oder Verbinden der Teile kann in analoger Weise zum oben beschriebenen Fall das Magnetfeld in der gemeinsamen Durchtrittsöffnung minimiert werden, indem die Körper in eine entsprechende Lage zueinander gebracht werden.

Die Körper können auch aus mehr als zwei, beispielsweise drei oder vier Segmenten bestehen. Dies ist bei größeren Körpern vorteilhaft, da die einzelnen Segmente dann auf Grund ihres geringeren Eigengewichts leichter handhabbar sind.

In einer besonders vorteilhaften Ausgestaltung der Erfindung sind die Körper rotationssymmetrisch und hier insbesondere Ringe, vorzugsweise konzentrische Ringe. Diese lassen sich mit geringem Drehmoment gegeneinander verdrehen, und sie lassen eine vergleichsweise große gemeinsame Durchtrittsöffnung für die Probe offen.

Die Ringe können koplanar angeordnet sein. Dies ist vorteilhaft, wenn die Vorrichtung um eine längliche Probe geschlossen werden soll, deren Enden nicht zugänglich sind. Es ist dann in der Regel nur noch eine koplanare oder nahezu koplanare Drehung der Ringe gegeneinander möglich. Unter "nahezu koplanar" im Sinne dieser Erfindung werden auch noch Ringe verstanden, die um bis zu 10 Grad gegeneinander verkippt sind.

In einer besonders vorteilhaften Ausgestaltung der Erfindung bestehen die schleifenförmigen

Körper aus nicht ferromagnetischem Material, wie beispielsweise Aluminium, und umfassen Permanentmagnete. Als Werkstoff für die Permanentmagnete sind hierbei insbesondere NdFeB und/oder Sm₂Co₇ geeignet. Es ist sehr schwierig, eine komplett aus magnetischem Material bestehende Schleife zu fertigen, die eine technisch relevante Magnetfeldverteilung im Inneren der gemeinsamen Durchtrittsöffnung erzeugt. Die Schleife müsste in so viele Abschnitte mit unterschiedlichen Magnetisierungen unterteilt werden, dass die gewünschte Feldverteilung schon auf Grund der Fertigungstoleranzen für die Abschnitte nicht mit hinreichender Genauigkeit eingehalten werden könnte. Die Feldstärken nominell identischer Permanentmagnete streuen fertigungsbedingt in einer Bandbreite von bis zu 5 Prozent zu beiden Seiten des Nominalwerts.

Die Anordnung der Permanentmagnete auf, am oder im nicht ferromagnetischen schleifenförmigen Körper ist dagegen mechanisch sehr genau kontrollierbar. Zudem können identische Permanentmagnete verwendet werden, die entlang des Schleifenumfangs lediglich anders orientiert sind. Somit ist nur ein Typ Permanentmagnet zu fertigen. Dies ist mit der geforderten Genauigkeit realisierbar.

Wie die Permanentmagnete im Einzelnen über die Schleife verteilt sein müssen, um im Inneren eine gegebene Feldverteilung zu erzeugen, kann vom Fachmann mit geläufigen Methoden wie etwa der Finite-Elemente-Rechnung ermittelt werden.

In einer besonders vorteilhaften Ausgestaltung sind die Permanentmagnete in einer Halbach-Geometrie (J. M. D. Coey, "Permanent Magnet Applications", Journal of Magnetism and Magnetic Materials 248, 441-456 (2002)) und hier insbesondere in einer Mandhala-Geometrie (H. Raich, P. Blümler: "Design and Construction of a Dipolar Halbach Array with a Homogeneous Field from Identical Bar Magnets: NMR Mandhalas", Concepts in Magnetic Resonance B 23B(1), 16-25 (2004)) angeordnet. Dadurch wird das Feld im Inneren der gemeinsamen Durchtrittsöffnung besonders homogen. Dies ist besonders vorteilhaft für Kernspinresonanz-Untersuchungen. Der schmalen Bandbreite der Anregungspulse, die für diese Untersuchungen verwendet werden, entspricht gemäß dem gyromagnetischen Verhältnis nur ein schmaler Bereich an magnetischen Feldstärken, zu denen diese Anregungspulse passen. Wäre das Magnetfeld nicht ausreichend homogen, würde nur ein Teil der Probe durch die Pulse angeregt, und die Messung würde verfälscht. Für eine Anordnung der Permanentmagnete in einer Halbach- oder Mandhala-Geometrie sind Ringe als schleifenförmige Körper besonders vorteilhaft.

In einer vorteilhaften Ausgestaltung der Erfindung haben die Permanentmagnete einen polygonalen Querschnitt und hier insbesondere einen Querschnitt mit n/2 Ecken für eine gerade Anzahl n verwendeter Magnete. Dadurch wird das Magnetfeld im Zentrum der gemeinsamen Durchtrittsöffnung sowohl stärker als auch homogener, und der Bereich, in dem das Magnetfeld diese Homogenität aufweist, wird ausgedehnt. Dies ist vorteilhaft für Kemspin-Resonanz-Untersuchungen, bei denen die Anforderungen an die Homogenität des Feldes besonders hoch sind.

Bei den konzentrischen Ringen kann es sich auch um stromdurchflossene Spulen handeln. Jedoch hat ein nicht ferromagnetischer Ring, der Permanentmagnete umfasst, den Vorteil, dass er zur Aufrechterhaltung des Magnetfeldes keine Energiequelle benötigt.

In einer weiteren vorteilhaften Ausgestaltung der Erfindung ist das magnetische Remanenzfeld jedes Körpers geringer als sein magnetisches Koerzitivfeld. Dann können die beiden Körper nahe beieinander liegen, ohne dass die Gefahr besteht, dass die Magnetisierung des einen Körpers durch die des anderen Körpers dauerhaft geändert (umgepolt) wird.

Vorteilhaft leisten die Körper identische oder nahezu identische Beiträge zum Magnetfeld in der gemeinsamen Durchtrittsöffnung. Dann kann dieses Feld durch die Drehung der beiden Körper gegeneinander nahezu neutralisiert werden. Die Vorrichtung kann in diesem Fall im Wesentlichen kräftefrei um die längliche Probe geschlossen und wieder geöffnet werden. Typischerweise wird die Vorrichtung so ausgestaltet, dass zum Umschalten zwischen maximalem und minimalem Magnetfeld in der gemeinsamen Durchtrittsöffnung eine Drehung der beiden Körper gegeneinander um etwa 180 Grad erforderlich ist.

Im Rahmen der Erfindung wurde eine Stapelung aus mehreren erfindungsgemäßen Vorrichtungen entwickelt, wobei es sich um solche Vorrichtungen handelt, die konzentrische Ringe als Körper aufweisen. In dieser Anordnung weisen alle Vorrichtungen eine gemeinsame Durchtrittsöffnung auf. Dadurch kann ein größeres Volumen der Probe auf einmal untersucht werden.

Unter einer gemeinsamen Durchtrittsöffnung wird insbesondere verstanden, dass eine starre längliche Probe die Stapelung durchdringen kann. Beispielsweise kann die Stapelung an einem Baumstamm oder an einer Rohrleitung entlang geführt werden.

In einer besonders vorteilhaften Ausgestaltung der Erfindung sind die Vorrichtungen in derartigen Abständen zueinander angeordnet, dass die Änderung des Magnetfelds entlang der gemeinsamen Symmetrieachse der Vorrichtungen in einem möglichst großen Bereich um die Stapelmitte herum minimal ist. Dieses Kriterium lässt sich durch Messung des Feldes entlang der Symmetrieachse während der Justage experimentell prüfen. Da die von den Vorrichtungen erzeugten Magnetfeldverteilungen bekannt sind, ist es aber auch möglich, die optimalen Abstände im Voraus durch eine Computersimulation zu berechnen. Lediglich die Abweichungen der realen Magnetverteilungen von den in der Computersimulation verwendeten Modellen wären dann noch experimentell nachzujustieren.

Ist das Magnetfeld entlang der gemeinsamen Symmetrieachse der Vorrichtungen konstant oder fast konstant, bleibt es vorteilhaft auch in einem großen Radius um die Symmetrieachse herum homogen.

Als besonders vorteilhaft hat sich im Hinblick auf die Homogenität des Feldes in der gemeinsamen Durchtrittsöffnung eine Stapelung erwiesen, bei der die Vorrichtungen spiegelsymmetrisch um die Stapelmitte angeordnet sind.

In einer besonders vorteilhaften Ausgestaltung der Erfindung ist in der gemeinsamen Durchtrittsöffnung mindestens eine Spule zur Beaufschlagung dieser gemeinsamen Durchtrittsöffnung mit einem magnetischen Gradientenfeld angeordnet. Neben dem durch die Stapelungen erzeugten statischen Magnetfeld wird bei vielen Magnetresonanzuntersuchungen, wie beispielsweise Kemspinresonanz, in der Regel ein solches Gradientenfeld benötigt.

Um von der gemeinsamen Durchtrittsöffnung möglichst wenig Raum auf die Spule zu verwenden, ist mindestens eine Flachspule vorteilhaft.

Flachspulen im Sinne dieser Erfindung müssen nicht planar sein, sondern können auch gebogen sein. Sie können insbesondere auf der Mantelfläche eines Hohlzylinders aufgebracht sein. Hier ist insbesondere ein Hohlzylinder vorteilhaft, der mindestens zwei Flachspulen umfasst. Es hat sich zudem experimentell herausgestellt, dass der Hohlzylinder ein besonders homogenes Gradientenfeld in seinem Inneren erzeugt, insbesondere dann, wenn die geometrischen Mittelpunkte mindestens zweier Flachspulen um einen Betrag auseinander liegen, der dem 1,3-fachen bis 1,6-fachen des Hohlzylinderradius entspricht. Es wurde ein Ausführungsbeispiel mit 2^{0,5} als Faktor realisiert.

Ein Gradient in mehreren Raumrichtungen lässt sich vorteilhaft mit einer Anordnung konzentrischer Hohlzylinder einstellen, die jeweils mindestens zwei Flachspulen umfassen. Dabei kann diese Anordnung insbesondere einen Hohlzylinder pro Raumrichtung enthalten, in der das Feld einen Gradienten aufweisen soll. Für die beiden Raumrichtungen in der Ebene der Ringe können dabei identische Hohlzylinder verwendet werden, die lediglich gegeneinander winkelversetzt sind. Um auch die Raumrichtung entlang der gemeinsamen Drehachse der Stapelungen zu erfassen, umfasst die Anordnung vorteilhaft einen Hohlzylinder, dessen Flachspulen den um 80 bis 100 Grad gedrehten Flachspulen auf einem anderen Hohlzylinder entsprechen.

### Spezieller Beschreibungsteil

Nachfolgend wird der Gegenstand der Erfindung anhand von Figuren näher erläutert, ohne dass der Gegenstand der Erfindung dadurch beschränkt wird. Es ist gezeigt:
- Figur 1:: Ausführungsbeispiel der erfindungsgemäßen Vorrichtung.
- Figur 2:: Ausschnitt aus einem Ausführungsbeispiel eines Körpers der Vorrichtung.
- Figur 3:: Ausführungsbeispiel der Optimierung der Abstände mehrerer Vorrichtungen in einer Stapelung.

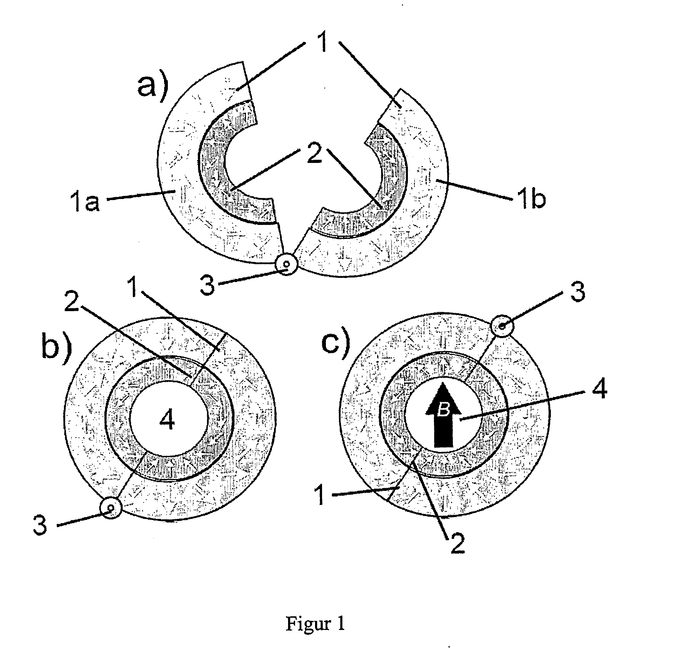

Figur 1 zeigt ein Ausführungsbeispiel der erfindungsgemäßen Vorrichtung. Diese umfasst zwei teilweise magnetische schleifenförmige Körper 1, bestehend aus zwei Segmenten 1a und 1b, und 2, bestehend aus zwei Segmenten 2a und 2b. Die beiden Segmente eines Körpers sind jeweils über Kopplungsmittel miteinander verbunden. In Figur 1 ist nur ein Scharnier 3 als Kopplungsmittel, welches eine Klappbewegung zulässt, eingezeichnet. Das erfindungsgemäß ebenfalls vorgesehene lösbar ausgestaltete Kopplungsmittel ist nicht eingezeichnet. Die Körper 1 und 2 sind gegeneinander drehbar angeordnet und weisen eine gemeinsame Durchtrittsöffnung 4 auf. Bei den Körpern handelt es sich um konzentrische, koplanare Ringe.

In Teilbild a ist das lösbar ausgestaltete Kopplungsmittel geöffnet; in den Teilbildern b und c ist es geschlossen.

Die Teilbilder b und c verdeutlichen den Einfluss einer Drehung der beiden Körper 1 und 2 gegeneinander auf das Magnetfeld in der gemeinsamen Durchtrittsöffnung 4.

In Teilbild b löschen sich die durch die Körper 1 und 2 bewirkten Magnetfelder fast vollständig aus. Dies ist der Zustand, in dem die Vorrichtung mit geringem Aufwand geöffnet und geschlossen werden kann.

In Teilbild c verstärken sich die durch die Körper 1 und 2 bewirkten Magnetfelder. Dies ist der Zustand, in dem in der gemeinsamen Durchtrittsöffnung 4 ein maximales Magnetfeld herrscht. Der Übergang zwischen den Teilbildern b und c entspricht einer Drehung der Körper 1 und 2 gegeneinander um 180 Grad um die gemeinsame Symmetrieachse.

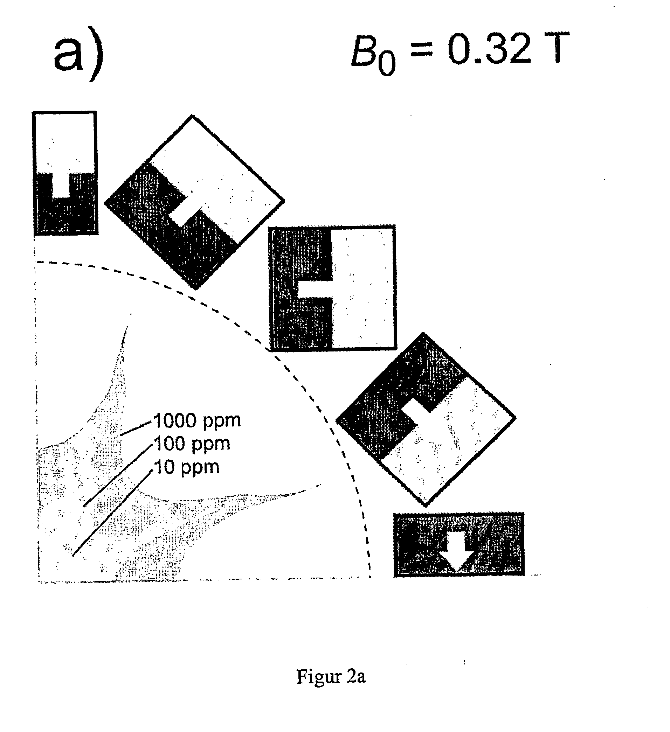

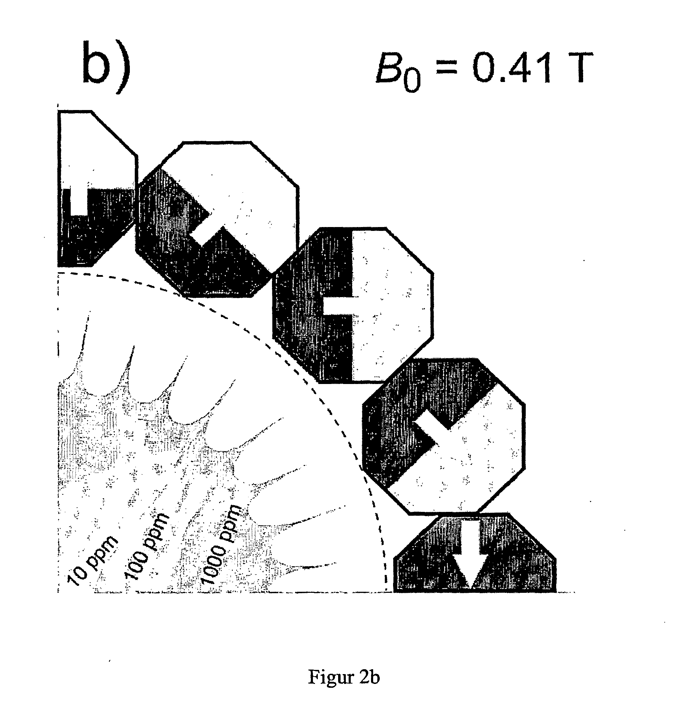

Figur 2 zeigt Ausschnitte aus Ausführungsbeispielen eines Körpers der Vorrichtung. Der Körper besteht aus 16 nominell identischen Permanentmagneten, die in einer Mandhala-Geometrie angeordnet sind und jeweils einen polygonalen Querschnitt mit einer geradzahligen Anzahl Ecken aufweisen. In dem in Teilbild a gezeigten Ausführungsbeispiel weisen die Permanentmagnete vier Ecken und in dem in Teilbild b gezeigten Ausführungsbeispiel acht Ecken auf. Links unten sind jeweils die Regionen eingezeichnet, in denen das Feld in der Ebene der Durchtrittsöffnung bis auf die angegebenen Toleranzgrenzen 10 ppm, 100 ppm beziehungsweise 1000 ppm homogen ist. Mit acht statt vier Ecken wird nicht nur eine deutlich bessere Homogenität des Feldes erreicht, es ist mit 0,41 statt 0,32 Tesla auch um 28 Prozent stärker. Das als gemeinsame Durchtrittsöffnung nutzbare, von den Körpern umschlossene Raumgebiet, welches durch eine gestrichelte Kreislinie markiert ist, ist in beiden Ausführungsbeispielen gleich groß.

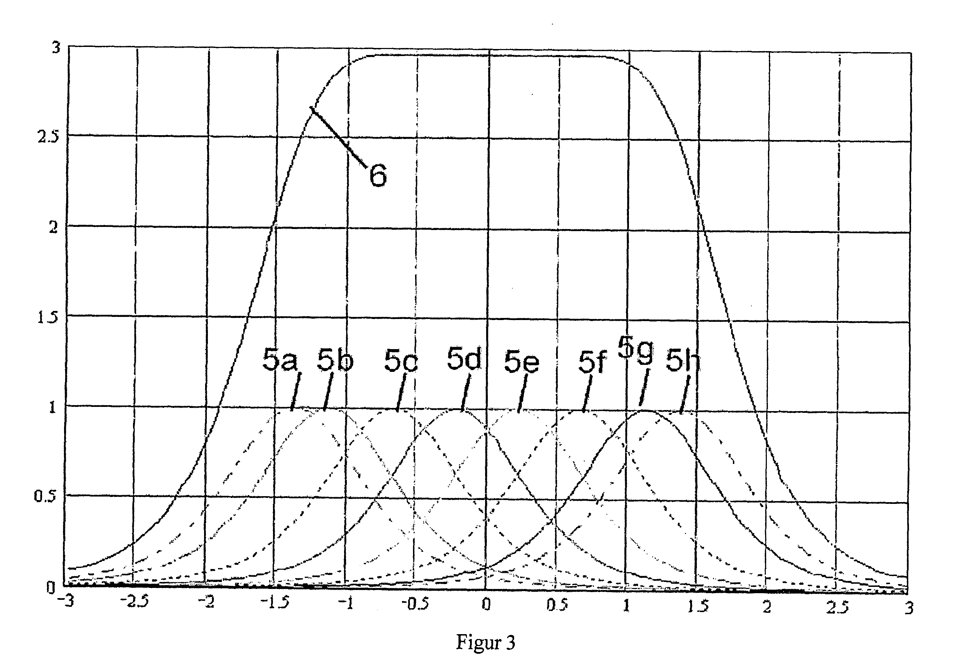

Figur 3 zeigt ein Ausführungsbeispiel der Optimierung der Abstände mehrerer Vorrichtungen in einer Stapelung. Die Vorrichtungen umfassen in diesem Ausführungsbeispiel jeweils konzentrische Ringe als schleifenförmige Körper. Alle in der Stapelung vorhandenen Ringe haben eine gemeinsame Symmetrieachse. Auf der Ordinate ist die Entfernung von der Mitte der Stapelung in Einheiten des Ringradius aufgetragen, wobei als Ringradius die radiale Entfernung vom Mittelpunkt des Rings bis zu den Schwerpunkten der Magnete angesehen wird. Auf der Abszisse ist in willkürlichen Einheiten das auf der gemeinsamen Symmetrieachse gemessene Magnetfeld aufgetragen. Die Stapelung umfasst acht Vorrichtungen a bis h; die Kurven 5a bis 5h geben den Verlauf der Magnetfelder an, die von diesen Vorrichtungen in jedem Punkt auf der gemeinsamen Symmetrieachse bewirkt werden. Die Kurve 6 ist die Summe aller Kurven 5a bis 5h und gibt das resultierende Magnetfeld in jedem Punkt auf der gemeinsamen Symmetrieachse an. Die Abstände zwischen den Maxima der Kurven 5a bis 5h entsprechen den Abständen der Vorrichtungen zueinander innerhalb der Stapelung. Bei den hier vorliegenden, numerisch mit Hilfe eines Computerprogramms optimierten, Abständen ist das resultierende Feld in einem weiten Bereich um die Mitte der Stapelung homogen, was sich in einem flachen Verlauf der Kurve 6 in diesem Bereich zeigt.

Nachfolgend werden beispielhaft optimierte Positionen der Vorrichtungen auf der gemeinsamen Symmetrieachse angegeben, wobei die Koordinate wie auf der Ordinatenachse von Figur 3 in Einheiten des Ringradius normiert ist:
2+2+2 Vorrichtungen:
   -1,001; -0,654; -0,234; 0,234; 0,654; 1,001
2+4+2 Vorrichtungen:
   -1,435; -1,106; -0,675; -0,222; 0,675; 1,106; 1,435
2+6+2 Vorrichtungen:
   -1,891; -1,544; -1,125; -0,669; -0,225; 0,225; 0,669; 1,125; 1,544; 1,891

## Patentansprüche

1. Vorrichtung zur Beaufschlagung einer Probe mit einem Magnetfeld, umfassend mindestens zwei innere und zwei äußere konzentrische Halbzylinder (1a, 1b, 2a, 2b), bestehend aus nicht ferromagnetischem Material, an, auf oder in denen Permanentmagnete angeordnet sind, mit einer gemeinsamen Durchtrittsöffnung (4) für die Probe, wobei die inneren Halbzyliunder (2a, 2b) drehbar gegen die äußeren Halbzylinder (1a, 1b) angeordnet sind,
und
wobei die inneren und äußeren Halbzylinder (1a, 1b, 2a, 2b) jeweils über mindestens zwei Kopplungsmittel verbunden sind, wovon mindestens ein Kopplungsmittel lösbar ausgestaltet ist,
und wobei ein an den äußeren Halbzylindern (1a,1b) angebrachtes Scharnier (3) eine Klappbewegung der Halbzylinder (1a, 1b, 2a, 2b) ermöglicht, wenn die äußeren (1a, 1b) Halbzylinder und die inneren Halbzylinder (2a,2b) um 0 Grad gegeneinander verdreht sind, so dass die magnetische Kraftwechselwirkung, die die beiden äußeren (1a,1b) und inneren (2a,2b) zusammenhält minimal ist gegenüber der um 180 Grad dazu verdrehten Position
und wobei die Halbzylinder (1a, 1b, 2a, 2b) auch nach Arretierung der lösbar ausgestalteten Kopplungsmittel gegeneinander drehbar ausgestaltet sind.

2. einer Probe mit einem Magnetfeld, umfassend mindes-2. Vorrichtung zur Beaufschlagung einer Probe mit einem Magnetfeld, umfassend mindestens zwei und zwei äußere konzentrische Halbzylinder (1a, 1b, 2a, 2b), bestehend aus nicht ferromagnetischem Material, an, auf oder in denen Permanentmagnete angeordnet sind, mit einer gemeinsamen Durchtrittsöffnung (4) für die Probe, wobei die inneren Halbzylinder (2a,2b) drehbar gegen die äußeren Halbzylinder (1a,1b) angeordnet sind, und wobei inneren und äußeren Halbzylinder (1a, 1b, 2a, 2b) jeweils über mindestens zwei lösbar ausgestaltete Kopplungsmittel verbunden sind,
und wobei lösbar ausgestalteten Kopplungsmittel das Zerlegen der Halbzylinder (1a,1b,2a, 2b) ermöglichen, wenn die äußeren (1a, 1b) und die inneren Halbzylinder (2a, 2b) um 0 Grad gegeneinander verdreht sind, so dass die magnetische Krafhwechselwirkung, die die beiden äußeren und inneren Halbzylinder (1a, 1b, 2a,2b) zusammenhält minimal ist gegenüber der um 180 Grad dazu verdrehten Position und wobei die Halbzylinder (1a, 1b, 2a, 2b) auch nach Arretierung der lösbar ausgestalteten Kopplungsmittel gegeneinander drehbar ausgestaltet sind.

3. Vorrichtung nach einem der vorhergehenden Ansprüche, **gekennzeichnet durch** eine Schnalle oder einen Schraubverschluss als lösbar ausgestaltetes Kopplungsmittel.

4. Vorrichtung nach einem der vorhergehenden Ansprüche **dadurch gekennzeichnet, dass** die konzentrischen Halbzylinder (1a, 1b, 2a, 2b) rotationssymmetrische Halbzylinder sind.

5. Vorrichtung nach einem der Ansprüche 1 bis 4, **gekennzeichnet durch** konzentrische Halbzylinder (1a, 1b, 2a, 2b), die in einer Halbach-Geometrie oder Mandhala-Geometrie angeordnete Permanentmagnete umfassen.

6. Vorrichtung nach Anspruch 5, **dadurch gekennzeichnet, dass** mindestens ein konzentrischer Halbzylinder (1a, 1b, 2a, 2b) n Permanentmagnete umfasst, wobei n eine gerade Zahl ist und dass die einzelnen Permanentmagnete einen polygonalen Querschnitt aufweisen mit n/2 Ecken.

7. Vorrichtung nach einem der vorhergehenden Ansprüche, **dadurch gekennzeichnet, dass** das magnetische Remanenzfeld jedes konzentrischen Halbzylinders (1a, 1b, 2a, 2b) geringer ist als sein magnetisches Koerzitivfeld.

8. Vorrichtung nach einem der vorhergehenden Ansprüche, gekenntzeichnet durch konzentrische Halbzylinder (1a, 1b, 2a, 2b), die identische Beiträge zum Magnetfeld in der gemeinsamen Durchtrittsöffnung (4) leisten.

9. Vorrichtung nach einem der Ansprüche 4 bis 8, **dadurch gekennzeichnet, dass** sie eine Stapelung aus mindestens zwei Vorrichtungen nach einem der Ansprüche 3 bis 8 umfasst, wobei die Halbzylinder (1a,1b, 2a, 2b) konzentrisch sind und alle Vorrichtungen eine gemeinsame Durchtrittsöffnung (4) aufweisen.

10. Vorrichtung nach Anspruch 9, **gekennzeichnet durch** Vorrichtungen, welche spiegelsymmetrisch um die Stapelmitte angeordnet sind.

11. Vorrichtung nach einem der Ansprüche 9 bis 10, **gekennzeichnet durch** mindestens eine in der gemeinsamen Durchtrittsöffnung (4) angeordnete Spule, Flachspule, einen Hoblzylinder umfassend mindestens zwei Flachspulen und/oder eine Anordnung konzentrischer Hohlzylinder, von denen jeder mindestens zwei Flachspulen umfasst, zur Beaufschlagung der gemeinsamen Durchtrittsöffnung (4) mit einem magnetischen Gradientenfeld.

12. Vorrichtung nach Anspruch 11, **dadurch gekennzeichnet, dass** die geometrischen Mittelpunkte mindestens zweier Flachspulen um einen Betrag auseinander liegen, der dem 1,3-fachen bis 1,6-fachen des Hohlzylinderradius entspricht.

13. Vorrichtung nach einem der Ansprüche 11 bis 12, wobei eine Anordnung konzentrischer Hohlzylinder vorliegt, **dadurch gekennzeichnet, dass** die Flachspulen in ihrer Ebene auf einem Hohlzylinder den um 80 bis 100 Grad gedrehten Flachspulen auf einem anderen Hohlzylinder entsprechen.

## Claims

1. Apparatus for applying a magnetic field to a sample, comprising at least two inner and two outer concentric half cylinders (1a, 1b, 2a, 2b), consisting of non-ferromagnetic materials, on or in which permanent magnets are arranged, with a common opening allowing passage (4) for the sample, in which the inner half cylinders (2a, 2b) are arranged so that they may rotate against the outer half cylinders (1a, 1b),
and
in which the inner and outer half cylinders (1a, 1b, 2a, 2b) are each connected through at least two means of coupling, of which at least one means of coupling may be made so that it is detachable,
and in which a hinge (3) applied to the outer half cylinders (1a, 1b) makes a folding movement of the half cylinders (1a, 1b, 2a, 2b) possible, if the outer (1a, 1b) half cylinders and the inner half cylinders (2a, 2b) are twisted against each other by 0 degrees, so that the magnetic interaction of forces, which holds both outer (1a, 1b) and inner half cylinders (2a, 2b) together, is minimal compared with the position twisted by 180 degrees with reference to it
and in which the half cylinders (1a, 1b, 2a, 2b) are made so that they may rotate against each other after locking the means of coupling, which is made so that it is detachable.

2. Apparatus for applying a magnetic field to a sample, comprising at least two inner and two outer concentric half cylinders (1a, 1b, 2a, 2b), consisting of non-ferromagnetic material, in or on which permanent magnets are arranged, with a common opening allowing passage (4) for the sample, in which the inner half cylinders (2a, 2b) are arranged so that they may rotate against the outer half cylinders (1a, 1b), and in which the inner and outer half cylinders (1a, 1b, 2a, 2b) are each connected through at least two means of coupling, which are made so that they are detachable, and in which the means of coupling, which are made so that they are detachable, make it possible to take apart the half cylinders (1a, 1b, 2a, 2b), if the outer (1a, 1b) and inner half cylinders (2a, 2b) are twisted against each other by 0 degrees, so that the magnetic interaction of forces, which holds both outer and inner half cylinders (1a, 1b, 2a, 2b) together, is minimal compared with the position twisted by 180 degrees with reference to it,
and in which the half cylinders (1a, 1b, 2a, 2b) are also made so that they may rotate against each other after locking the means of coupling, which is made so that it is detachable.

3. Apparatus according to one of the previous claims, **characterised by** a clasp or screw connection as the means of coupling, which is made so that it is detachable.

4. Apparatus according to one of the previous claims, **characterised in that** the concentric half cylinders (1a, 1b, 2a, 2b) are half cylinders, which are rotationally symmetrical.

5. Apparatus according to one of claims 1 to 4, **characterised by** concentric half cylinders (1a, 1b, 2a, 2b), which comprise permanent magnets arranged in Halbach geometry or Mandhala geometry.

6. Apparatus according to claim 5, **characterised in that** at least one concentric half cylinder (1a, 1b, 2a, 2b) comprises n permanent magnets, in which n is an even number, and that the individual permanent magnets have a polygonal cross section with n/2 corners.

7. Apparatus according to one of the previous claims, **characterised in that** the magnetic remanent field of each concentric half cylinder (1a, 1 b, 2a, 2b) is smaller than its magnetic coercive field.

8. Apparatus according to one of the previous claims, **characterised by** concentric half cylinders (1a, 1b, 2a, 2b), which make identical contributions to the magnetic field in the common opening allowing passage (4).

9. Apparatus according to one of claims 4 to 8, **characterised in that** it comprises a stack of at least two pieces of apparatus according to one of claims 3 to 8, in which the half cylinders (1a, 1b, 2a, 2b) are concentric and all the pieces of apparatus have a common opening allowing passage (4).

10. Apparatus according to claim 9, **characterised by** pieces of apparatus, which are arranged around the middle of the stack mirror symmetrically.

11. Apparatus according to one of claims 9 to 10, **characterised by** at least one coil arranged in the common opening allowing passage (4), a flat coil, a hollow cylinder comprising at least two flat coils and/or an arrangement of concentric hollow cylinders, each of which comprises at least two flat coils, for applying a magnetic gradient field to the common opening allowing passage (4).

12. Apparatus according to claim 11, **characterised in that** the geometrical centres of at least two flat coils lie at a distance from each other, which corresponds to 1.3 times to 1.6 times the hollow cylinder radius.

13. Apparatus according to one of claims 11 to 12, in which there is an arrangement of concentric hollow cylinders, **characterised in that** in their plane on a hollow cylinder the flat coils correspond to the flat coils on another hollow cylinder twisted by 80 to 100 degrees.

## Revendications

1. Dispositif pour l'application d'un champ magnétique à un échantillon, comprenant au moins deux demi-cylindres concentriques intérieurs et deux demi-cylindres concentriques extérieurs (1a, 1b, 2a, 2b) se composant d'un matériau non ferromagnétique, sur, contre ou dans lesquels des aimants permanents sont disposés, avec une ouverture traversante commune (4) pour l'échantillon, les demi-cylindres intérieurs (2a, 2b) étant disposés de manière rotative par rapport aux demi-cylindres extérieurs (1a, 1b), et
les demi-cylindres intérieurs et extérieurs (1a, 1b, 2a, 2b) étant respectivement reliés par l'intermédiaire d'au moins deux moyens d'accouplement, au moins l'un des moyens d'accouplement étant réalisé de manière détachable,
et une charnière (3) aménagée sur les demi-cylindres extérieurs (1a, 1b) permettant un mouvement de repli des demi-cylindres (1a, 1b, 2a, 2b) lorsque les demi-cylindres extérieurs (1a, 1b) et les demi-cylindres intérieurs (2a, 2b) sont en torsion de 0 degrés les uns par rapport aux autres, de sorte que la force d'interaction magnétique qui maintient ensemble les deux demi-cylindres extérieurs (1a, 1b) et intérieurs (2a, 2b) est minimale par rapport à la position de torsion de 180 degrés,
et les demi-cylindres (1a, 1b, 2a, 2b) étant réalisés de manière à pouvoir tourner les uns par rapport aux autres également après l'arrêt des moyens d'accouplement réalisés de manière détachable.

2. Dispositif pour l'application d'un champ magnétique à un échantillon, comprenant au moins deux demi-cylindres concentriques intérieurs et deux demi-cylindres concentriques extérieurs (1a, 1b, 2a, 2b) se composant d'un matériau non ferromagnétique, sur, contre ou dans lesquels des aimants permanents sont disposés, avec une ouverture traversante commune (4) pour l'échantillon, les demi-cylindres intérieurs (2a, 2b) étant disposés de manière rotative par rapport aux demi-cylindres extérieurs (1a, 1b), et les demi-cylindres intérieurs et extérieurs (1a, 1b, 2a, 2b) étant respectivement reliés par l'intermédiaire d'au moins deux moyens d'accouplement réalisés de manière détachable,
et les moyens d'accouplement réalisés de manière détachable permettant le désassemblage des demi-cylindres (1a, 1b, 2a, 2b) lorsque les demi-cylindres extérieurs (1a, 1b) et intérieurs (2a, 2b) sont en torsion les uns par rapport aux autres de 0 degrés, de sorte que la force d'interaction magnétique qui maintient ensemble les deux demi-cylindres extérieurs et intérieurs (1a, 1b, 2a, 2b) est minimale par rapport à la position de torsion de 180 degrés,
et les demi-cylindres (1a, 1b, 2a, 2b) étant réalisés de manière à pouvoir tourner les uns par rapport aux autres également après l'arrêt des moyens d'accouplement réalisés de manière détachable.

3. Dispositif selon l'une des revendications précédentes, **caractérisé par** une boucle ou une fermeture à vis en tant que moyen d'accouplement réalisé de manière détachable.

4. Dispositif selon l'une des revendications précédentes, **caractérisé en ce que** les demi-cylindres concentriques (1a, 1b, 2a, 2b) sont des demi-cylindres à symétrie de rotation.

5. Dispositif selon l'une des revendications 1 à 4, **caractérisé par** des demi-cylindres concentriques (1a, 1b, 2a, 2b), lesquels englobent des aimants permanents disposés selon une géométrie de Halbach ou une géométrie de Mandala.

6. Dispositif selon la revendication 5, **caractérisé en ce qu'**au moins un demi-cylindre concentrique (1a, 1b, 2a, 2b) comprend n aimants permanents, n étant un nombre pair, et **en ce que** les aimants permanents individuels présentent une section transversale polygonale avec n/2 angles.

7. Dispositif selon l'une des revendications précédentes, **caractérisé en ce que** le champ de rémanence magnétique de chaque demi-cylindre concentrique (1a, 1b, 2a, 2b) est plus faible que son champ coercitif magnétique.

8. Dispositif selon l'une des revendications précédentes, **caractérisé par** des demi-cylindres concentriques (1a, 1b, 2a, 2b), lesquels offrent une contribution identique au champ magnétique dans l'ouverture traversante commune (4).

9. Dispositif selon l'une des revendications 4 à 8, **caractérisé en ce qu'**il comprend un empilage d'au moins deux dispositifs selon l'une des revendications 3 à 8, les demi-cylindres (1a, 1b, 2a, 2b) étant concentriques et tous les dispositifs présentant une ouverture traversante commune (4).

10. Dispositif selon la revendication 9, **caractérisé par** des dispositifs, lesquels sont disposés en symétrie spéculaire autour du centre de la pile.

11. Dispositif selon l'une des revendications 9 à 10, **caractérisé par** la disposition dans l'ouverture traversante commune (4) d'au moins une bobine, bobine plate, un cylindre creux comprenant au moins deux bobines plates et/ou un agencement de cylindres creux concentriques, chacun d'entre eux comprenant au moins deux bobines plates, pour appliquer à l'ouverture traversante commune (4) un champ de gradient magnétique.

12. Dispositif selon la revendication 11, **caractérisé en ce que** les points médians géométriques d'au moins deux bobines plates sont espacés l'un par rapport à l'autre de l'ordre correspondant à 1,3 à 1,6 fois le rayon du cylindre creux.

13. Dispositif selon l'une des revendications 11 à 12, avec la présence d'un agencement de cylindres creux concentriques, **caractérisé en ce que** les bobines plates correspondent dans leur plan sur un cylindre creux aux bobines plates tournées de 80 à 100 degrés sur un autre cylindre creux.
